# EUROPEAN PATENT APPLICATION

(11) **EP 4 414 665 A1**
(43) Date of publication of application: **14.08.2024**
(21) Application number: 22878565.5
(22) Date of filing: 05.10.2022
(51) Int. Cl.: G01D 5/245, H02K 11/215

(54) **MOTOR POSITION DETECTION SYSTEM**

(30) Priority: 08.10.2021 JP 2021166284
(71) Applicant: Panasonic Intellectual Property Management Co., Ltd., Kadoma-shi, Osaka 571-0057 (JP)
(72) Inventor: ONAKA, Kazuhiro, Kadoma-shi, Osaka 571-0057 (JP); ICHINOMIYA, Noritaka, Kadoma-shi, Osaka 571-0057 (JP)
(74) Representative: Novagraaf International SA
(86) International application number: PCT/JP2022/037329
(87) International publication number: WO 2023/058697

(57) **Abstract**

The problem is to provide a position detection system for use in motors which may contribute to expanding the detection area. In a motor (300) including a coil (301) and a drive magnet (302) that applies a drive magnetic field to the coil (301), the drive magnet (302) has a magnetized surface (302a) aligned with a magnetization direction and facing a coil surface (301a) and a driving direction of the motor (300) is aligned with the magnetization direction. The driving direction is a direction in which one member selected from the coil (301) and the drive magnet (302) is displaced with respect to the other member. The position detection system (200) includes a magnetic sensor (100) and a processing circuit (201). The magnetic sensor (100) includes a base member (73), a wiring layer (W1) disposed on a base member surface (73a) as a surface of the base member (73), and a bias magnet (5) that applies a bias magnetic field to the wiring layer (W1). The magnetic sensor (100) is arranged such that the base member surface (73a) is parallel to the magnetization direction and perpendicular to the magnetized surface (302a).

## Description

### Technical Field

The present disclosure generally relates to a position detection system for use in motors. More particularly, the present disclosure relates to a position detection system for use in motors such as a voice coil motor (VCM) which forms part of a camera module for mobile electronic devices.

### Background Art

A magnetic sensor has been used extensively in known mobile electronic devices such as cellphones, smartphones, and tablet computers to control a motor such as a VCM or to make position detection for a pointing device and for other purposes.

For example, Patent Literature 1 discloses a pointing device including a printed board and a ferrite magnet. In the pointing device, two Hall elements are arranged on the printed board to be separated from each other by 6 mm and the position (magnet position) of the ferrite magnet with respect to the printed board is detected based on the difference in output between the two Hall elements. Thus, the range in which position detection may be made (i.e., a detection area) is a range where the output difference changes linearly with respect to the magnet position. Specifically, supposing a position of the ferrite magnet where the distances from the two Hall elements to the ferrite magnet are equal to each other is an origin, the detection area is a range from -2 mm to +2 mm (i.e., a range with a width of 4 mm in total).

Also, in a camera module for use in mobile electronic devices, a positional relationship between a magnet fixed with respect to one member selected from a lens or a camera body and a coil fixed with respect to the other member, for example, is detected using a magnetic sensor with respect to a VCM for use in autofocusing (A/F). Based on the result of the detection and an image captured by an image sensor provided for the camera body, A/F is performed by moving the lens using the VCM.

Nevertheless, using the pointing device of Patent Literature 1 in such a VCM for autofocusing would cause the following problem. Specifically, lenses each having an even longer focal length have recently been used more and more often in a camera module for smartphones as camera modules with multiple lenses, such as twin-lens and triple-lens reflex cameras, have been developed one after another. The longer the focal length of a lens is, the broader the movable range of the lens needs to be for the purpose of A/F, thus creating a need for providing an even broader detection area.

### Citation List

### Patent Literature

Patent Literature 1: JP 2003-318459 A

### Summary of Invention

An object of the present disclosure is to provide a position detection system for use in motors which may contribute to expanding the detection area.

A position detection system according to an aspect of the present disclosure is designed for use in a motor. The motor includes a coil to be supplied with electric power and a drive magnet that applies a drive magnetic field to the coil. In the motor, the drive magnet has a magnetized surface aligned with a magnetization direction and facing a coil surface of the coil. In the motor, a driving direction thereof is aligned with the magnetization direction. The driving direction is a direction in which one member selected from the group consisting of the coil and the drive magnet is displaced with respect to the other member. The position detection system detects a position of the one member selected from the group consisting of the coil and the drive magnet with respect to the other member. The position detection system includes a magnetic sensor and a processing circuit that processes the output signal of the magnetic sensor. The magnetic sensor is disposed at a fixed position with respect to the coil and in the vicinity of the coil surface and the magnetized surface. The magnetic sensor delivers at least an output signal representing a magnetoresistance effect produced by the drive magnetic field generated from the drive magnet. The magnetic sensor includes a base member, a wiring layer, and a bias magnet. The base member has a base member surface. The base member surface is a surface on which an X-axis and a Y-axis perpendicular to the X-axis are defined. The wiring layer is disposed along the base member surface and includes a first half-bridge circuit and a second half-bridge circuit. The bias magnet applies a bias magnetic field to the wiring layer. The first half-bridge circuit includes a pair of first magnetoresistance effect elements and a first output terminal. The pair of first magnetoresistance effect elements are half-bridge connected to detect a magnetic field aligned with the X-axis. The first output terminal is a terminal, through which a first output signal is delivered from a connection node between the pair of first magnetoresistance effect elements. The second half-bridge circuit includes a pair of second magnetoresistance effect elements and a second output terminal. The pair of second magnetoresistance effect elements are half-bridge connected to detect a magnetic field aligned with the Y-axis. The second output terminal is a terminal, through which a second output signal is delivered from a connection node between the pair of second magnetoresistance effect elements. The bias magnet applies a bias magnetic field aligned with a positive direction of the X-axis to one of the pair of first magnetoresistance effect elements and applies a bias magnetic field aligned with a negative direction of the X-axis to the other of the pair of first magnetoresistance effect elements. The bias magnet applies a bias magnetic field aligned with a positive direction of the Y-axis to one of the pair of second magnetoresistance effect elements and applies a bias magnetic field aligned with a negative direction of the Y-axis to the other of the pair of second magnetoresistance effect elements. The magnetic sensor is arranged such that the base member surface is parallel to the magnetization direction and perpendicular to the magnetized surface. The processing circuit determines, based on at least one of the first output signal or the second output signal, an orientation of a magnetic field in which the drive magnetic field applied to the magnetic sensor and the bias magnetic field applied to the wiring layer forming part of the magnetic sensor are superposed one on top of the other and thereby detects the position of the one member selected from the group consisting of the coil and the drive magnet with respect to the other member.

### Brief Description of Drawings

FIG. 1A is a front view of a motor in which a position detection system according to an exemplary embodiment of the present disclosure is used;
FIG. 1B is a side view of the motor;
FIG. 2 is a side view illustrating a positional relationship between a magnetic sensor forming part of the position detection system and a mount board for a coil forming part of the motor;
FIG. 3 is a plan view of the magnetic sensor;
FIG. 4 is a schematic representation illustrating how the magnetic sensor may be used;
FIG. 5 is a cross-sectional view of a magnetoresistance effect element of the magnetic sensor;
FIG. 6A is an equivalent circuit diagram of a first half-bridge circuit and a third half-bridge circuit of the magnetic sensor;
FIG. 6B is an equivalent circuit diagram of a second half-bridge circuit and a fourth half-bridge circuit of the magnetic sensor;
FIG. 7 is a conceptual diagram showing a driving direction and an orientation of a drive magnetic field of a drive magnet forming part of the motor;
FIG. 8A shows the waveform of a first output signal of the first half-bridge circuit;
FIG. 8B shows the waveform of a second output signal of the second half-bridge circuit;
FIG. 9 shows a Lissajous waveform based on the first output signal and the second output signal;
FIG. 10A shows, for the purpose of comparison, a detection area based on two output signals of known two Hall sensors (labeled as "Hall Sensors Two phases");
FIG. 10B shows a detection area based on one of two output signals of two GMR sensors (labeled as "GMR Sensor Single Phase");
FIG. 10C shows a detection area based on a result of arithmetic operation on the two output signals shown in FIG. 10B (labeled as "GMR sensors Two phases");
FIG. 11A is a front view illustrating a first variation of the motor; and
FIG. 11B is a front view illustrating a second variation of the motor.

### Description of Embodiments

The drawings to be referred to in the following description of embodiments are all schematic representations. Thus, the ratio of the dimensions (including thicknesses) of respective constituent elements illustrated on the drawings does not always reflect their actual dimensional ratio. Note that the exemplary embodiment to be described below is only an exemplary one of various embodiments of the present disclosure and should not be construed as limiting. Rather, the exemplary embodiment may be readily modified in various manners depending on a design choice or any other factor without departing from the scope of the present disclosure.

### (1) Overview

A position detection system 200 according to an exemplary embodiment of the present disclosure is designed for use in a motor 300. The motor 300 is used to allow a camera (camera module) built in a mobile electronic device such as a smartphone to make autofocusing (A/F). Specifically, the motor 300 may be a VCM.

Alternatively, the motor 300 may also be a linear motor other than a VCM. As used herein, the "linear motor" refers to a motor, of which the driving direction (to be described later) is aligned with a line.

### (1-1) Motor

The motor 300 includes a coil 301 and a drive magnet 302.

The coil 301 is supplied with electric power from a power supply circuit or a power cable (not shown), for example. The drive magnet 302 applies a drive magnetic field to the coil 301.

Supplying electric power to the coil 301 to which the drive magnetic field is applied from the drive magnet 302 causes one member selected from the drive magnet 302 and the coil 301 to be displaced with respect to the other member.

### (1-1-1) Drive magnet

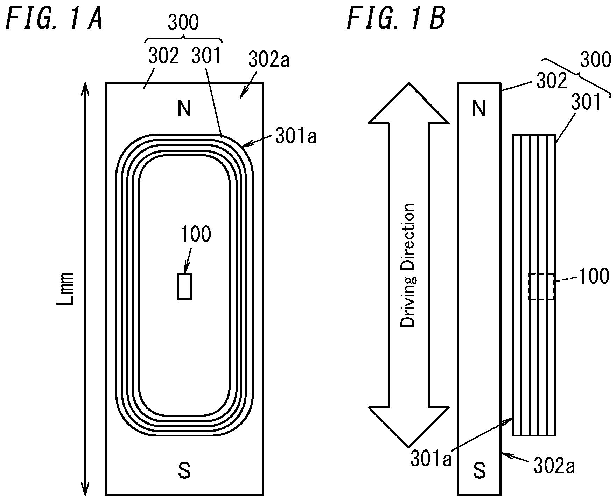

As shown in FIGS. 1A and 1B, the drive magnet 302 according to this embodiment is a unipolar magnetized magnet, one end of which is N-pole and the other end of which is S-pole, and has the shape of a plate which is elongate in the magnetization direction.

As used herein, the "magnetization direction" refers to the direction in which the line that connects the N-pole and the S-pole together extends (longitudinal direction) in a unipolar magnetized magnet such as the one shown in FIG. 1A.

### (1-1-2) Coil surface and magnetized surface

In the motor 300, the magnetized surface 302a of the drive magnet 302 faces the coil surface 301a of the coil 301.

As used herein, the magnetized surface 302a refers to a surface aligned with the magnetization direction of the drive magnet 302 and facing the coil surface 301a. The coil surface 301a as used herein refers to a surface aligned with the winding of the coil 301 (i.e., a surface intersecting at right angles with the axis of the coil 301).

The coil surface 301a has the shape of a rectangle (or an ellipse), of which the length (or the major-axis dimension) is defined in a direction parallel to the magnetization direction of the drive magnet 302 (i.e., the direction in which the line that connects the N-pole and the S-pole together extends) and the width (or the minor-axis dimension) is defined in a direction perpendicular to the magnetization direction of the drive magnet 302 as shown in FIG. 1A, for example.

In the example shown in FIG. 1A, the length (major-axis dimension) of the coil surface 301a is approximately three-quarters of the length L (of 5 mm, for example) of the magnetized surface 302a as measured in a direction parallel to the magnetization direction (i.e., in the longitudinal direction). In addition, the width (minor-axis dimension) of the coil surface 301a is somewhat smaller than the width of the magnetized surface 302a as measured in the direction perpendicular to the magnetization direction.

As shown in FIG. 1A, the magnetized surface 302a has the shape of a rectangle which is elongate in the magnetization direction and has a larger dimension than the coil surface 301a. Thus, in a state where the drive magnet 302 is located at the center of the drive area, the coil surface 301a is covered with the magnetized surface 302a.

Also, in the direction parallel to the magnetization direction, the centerline of the magnetized surface 302a (i.e., the axis of symmetry of the magnetization direction) is aligned with the centerline of the coil surface 301a (i.e., the axis of symmetry of the magnetization direction). Alternatively, the centerline of the coil surface 301a may also be misaligned with the centerline of the magnetized surface 302a (refer to the second variation to be described later).

Note that the shape of the coil surface 301a does not have to be rectangular or elliptical but may also be circular or polygonal such as hexagonal.

### (1-1-3) Driving direction

As shown in FIG. 1B, the driving direction of the drive magnet 302 is aligned with the magnetization direction of the drive magnet 302.

As used herein, the driving direction refers to a direction in which one member selected from the coil 301 and the drive magnet 302 is displaced with respect to the other member.

As described above, the motor 300 according to this embodiment is a VCM for use in a camera module, the coil 301 is disposed at a fixed position with respect to the camera body, and the drive magnet 302 is disposed at a fixed position with respect to the lens. Thus, the driving direction according to this embodiment is the direction in which the drive magnet 302 is displaced with respect to the coil 301. However, this is only an example and should not be construed as limiting. Alternatively, the coil 301 may be fixed with respect to the lens and the drive magnet 302 may be fixed with respect to the camera body. In that case, the driving direction will be a direction in which the coil 301 is displaced with respect to the drive magnet 302.

Also, in this embodiment, the drive magnet 302 has the shape of an elongate plate and the driving direction is aligned with the longitudinal axis of the drive magnet 302.

### (1-1-4) Drive area

As used herein, the "drive area" refers to a range in which one member selected from the coil 301 and the drive magnet 302 may be displaced with respect to the other member.

In this embodiment, the drive area is a range in which the drive magnet 302 may be displaced with respect to the coil 301 and its length is approximately the same as the length of the drive magnet 302. For example, the drive area may be a range from -(L/2) to +(L/2) with respect to the longitudinal middle of the coil surface 301a, where L is the length of the drive magnet 302. Thus, a drive magnet 302 with a length of 5 mm, for example, may have a drive area of -2.5 mm to +2.5 mm with a total length of 5 mm. Nevertheless, the total length of the drive area does not have to perfectly agree with the length L of the drive magnet 302. Rather, the drive area may fall within a range of ±α with respect to the length L, for example, where α is an appropriate numerical value such as 5% or 0.1 and may be determined by either experiment or simulation.

### (1-2) Position detection system for use in motors

The position detection system 200 for use in motors detects the position of one member selected from the coil 301 and the drive magnet 302 that form the motor 300 with respect to the other member. The position thus detected is the same as the position of a lens with respect to a camera body (image sensor) in a camera module.

In this embodiment, the position of the drive magnet 302 with respect to the coil 301 is detected. Then, a camera module (not shown) is notified of positional information indicating the result of detection. The positional information may be, for example, a coordinate on the axis of coordinates (such as the z-axis) defined in the driving direction but may also be a distance traveled.

### (1-3) Camera module

In the camera module, an A/F circuit (not shown) provided for the camera body (not shown) performs A/F using the motor 300 based on the positional information provided by the position detection system 200 for use in motors and the image captured by an image sensor provided for the camera body, thereby moving the lens (not shown) toward a focus position.

### (2) Details of position detection system for use in motors

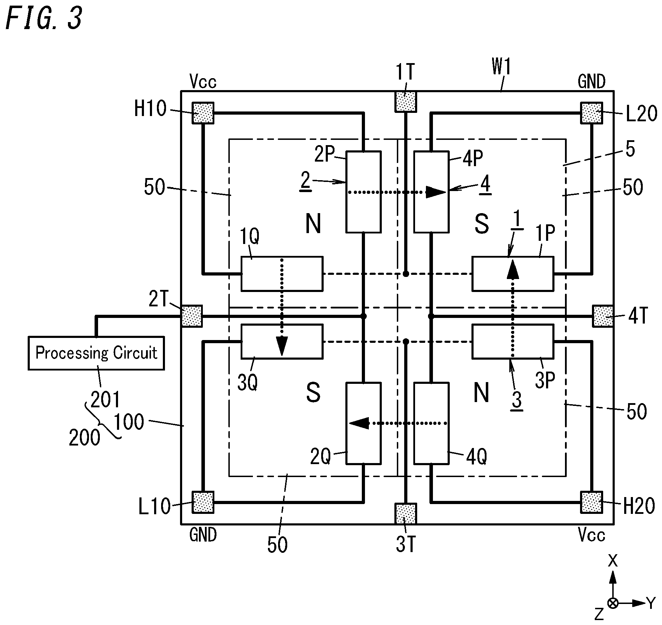

The position detection system 200 for use in motors includes a magnetic sensor 100 and a processing circuit 201 as shown in FIG. 3. The magnetic sensor 100 detects magnetoresistance effect produced by a magnetic field and delivers an output signal representing the result of detection. The processing circuit 201 processes the output signal of the magnetic sensor 100.

### (2-1) Sensor arrangement

The magnetic sensor 100 is disposed at a fixed position with respect to the coil 301. In addition, the magnetic sensor 100 is also disposed in the vicinity of the coil surface 301a of the coil 301 and the magnetized surface 302a of the drive magnet 302.

### (2-1-1) Sensor arrangement in direction parallel to magnetization direction (driving direction)

In front view of the magnetized surface 302a, the magnetic sensor 100 is disposed at the center of the coil surface 301a in a direction parallel to the magnetization direction.

### (2-1-2) Position in direction perpendicular to magnetization direction (driving direction)

Also, in front view of the magnetized surface 302a, the magnetic sensor 100 is disposed at the center of the coil surface 301a in a direction perpendicular to the magnetization direction.

That is to say, in this embodiment, the magnetic sensor 100 is located at the center of the coil surface 301a in the two directions, namely, in the direction parallel to the magnetization direction and in the direction perpendicular to the magnetization direction. Note that the "center" as used herein refers to an intersection between the diagonals if the coil surface 301a has a rectangular shape and refers to a center point if the coil surface 301a has an oblate shape. Alternatively, the center may also be located in the vicinity of the intersection or the center point. As used herein, if the center is located in the vicinity of the intersection or the center point, then the center may fall within a range where the distance from the intersection or the center point is equal to or less than a threshold value. The threshold value may be, for example, equal to or less than 5% of the length of the diagonals or 1/10 of the major axis dimension of the oblate shape but may also be any other appropriate value.

### (2-1-3) Number of sensors

In this embodiment, only one magnetic sensor 100 is disposed at the above-described position with respect to the coil 301 as shown in FIG. 1A.

As will be described in detail later, disposing even only one magnetic sensor 100 to have an orientation to be described below with respect to the magnetized surface 302a enables ensuring a detection area which is broader than the one disclosed in Patent Literature 1. In addition, disposing only one magnetic sensor 100 (i.e., setting the number of sensors at one) eliminates the chances of causing a phase shift that is likely to be caused when two or more magnetic sensor are arranged (i.e., a phase shift of an output signal due to an error during a mounting process or a difference between individual products), thus contributing to improving the detection accuracy.

### (2-1-4) Sensor orientation

The magnetic sensor 100 is arranged such that the base member surface 73a thereof is parallel to the magnetization direction and perpendicular to the magnetized surface 302a.

Note that as used herein, if something is "parallel" or "perpendicular" to something else, then these two things do not have to be perfectly parallel or perpendicular to each other. For example, if the two things are not perfectly parallel or perpendicular to each other but the difference falls within ±θ degrees, for example, then the two things may also be regarded as parallel or perpendicular to each other, where θ may be, but does not have to be, 5 degrees or 2 degrees, for example.

In addition, in this embodiment, the driving direction is parallel to the magnetization direction and the base member surface 73a is parallel to the magnetization direction. This means that the base member surface 73a is parallel to the driving direction.

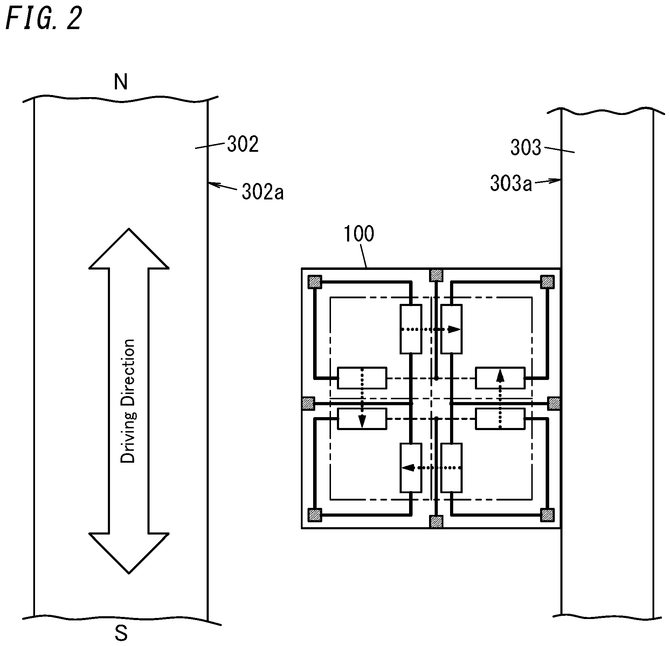

In this embodiment, the magnetic sensor 100 is provided on a mount board 303 as shown in FIG. 2. That is to say, the motor 300 further includes the mount board 303. The mount board 303 is a board on which the coil 301 is mounted and has a mount surface 303a facing the coil surface 301a.

The magnetic sensor 100 is provided on the mount board 303 such that the base member surface 73a is perpendicular to the mount surface 303a. This allows the magnetic sensor 100 to be fixed at such a position with respect to the coil 301 to have a right orientation.

### (2-1-5) Sensor capability and sensor structure

The magnetic sensor 100 detects the magnetoresistance effect produced by the drive magnetic field generated by the drive magnet 302 and outputs a signal representing the result of detection. Note that the output signal of the magnetic sensor 100 is also affected by a bias magnetic field generated by a bias magnet 5 (to be described later) forming part of the magnetic sensor 100.

The magnetoresistance effect detected by the magnetic sensor 100 is preferably giant magnetoresistance (GMR) effect or tunnel magnetoresistance (TMR) effect but may also be anisotropic magnetoresistance (AMR) effect. The magnetoresistance effect to be detected in this embodiment is the GMR effect.

The magnetic sensor 100 includes a base member 73, a wiring layer W1, and a bias magnet 5.

The base member 73 has a base member surface 73a. The base member surface 73a is a surface on which an X-axis and a Y-axis perpendicular to the X-axis are defined. The base member 73 ordinarily has a plate shape but may also have any other shape without limitation.

The wiring layer W1 is disposed along the base member surface 73a. The bias magnet 5 applies a bias magnetic field to the wiring layer W1.

The wiring layer W1 includes a first half-bridge circuit 1 and a second half-bridge circuit 2.

The first half-bridge circuit 1 includes a pair of first magnetoresistance effect elements 1P, 1Q and a first output terminal 1T. The pair of first magnetoresistance effect elements 1P, 1Q are half-bridge connected to detect a magnetic field aligned with the X-axis. The first output terminal 1T is a terminal through which the first output signal is delivered from the connection node between the pair of first magnetoresistance effect elements 1P, 1Q.

The second half-bridge circuit 2 includes a pair of second magnetoresistance effect elements 2P, 2Q and a second output terminal 2T. The pair of second magnetoresistance effect elements 2P, 2Q are half-bridge connected to detect a magnetic field aligned with the Y-axis. The second output terminal 2T is a terminal through which the second output signal is delivered from the connection node between the pair of second magnetoresistance effect elements 2P, 2Q.

Note that the wiring layer W1 according to this embodiment further includes a third half-bridge circuit 3 for delivering a third output signal, of which the phase is opposite from the phase of the first output signal, and a fourth half-bridge circuit 4 for delivering a fourth output signal, of which the phase is opposite from the phase of the second output signal (see "Details of magnetic sensor" section to be described later).

The bias magnet 5 applies a bias magnetic field aligned with the positive direction of the X-axis to one of the pair of first magnetoresistance effect elements 1P, 1Q and applies a bias magnetic field aligned with the negative direction of the X-axis to the other of the pair of first magnetoresistance effect elements 1P, 1Q.

Also, the bias magnet 5 applies a bias magnetic field aligned with the positive direction of the Y-axis to one of the pair of second magnetoresistance effect elements 2P, 2Q and applies a bias magnetic field aligned with the negative direction of the Y-axis to the other of the pair of second magnetoresistance effect elements 2P, 2Q.

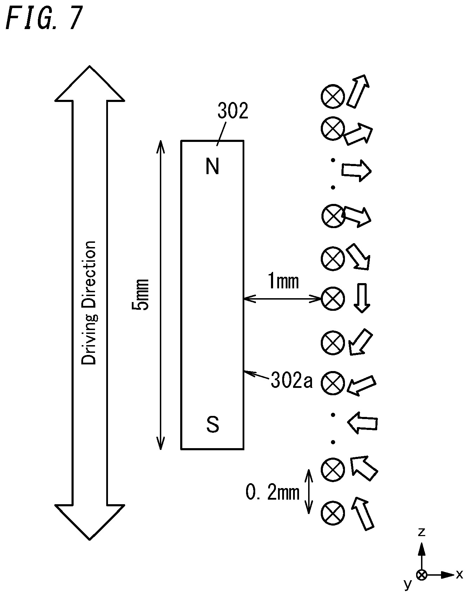

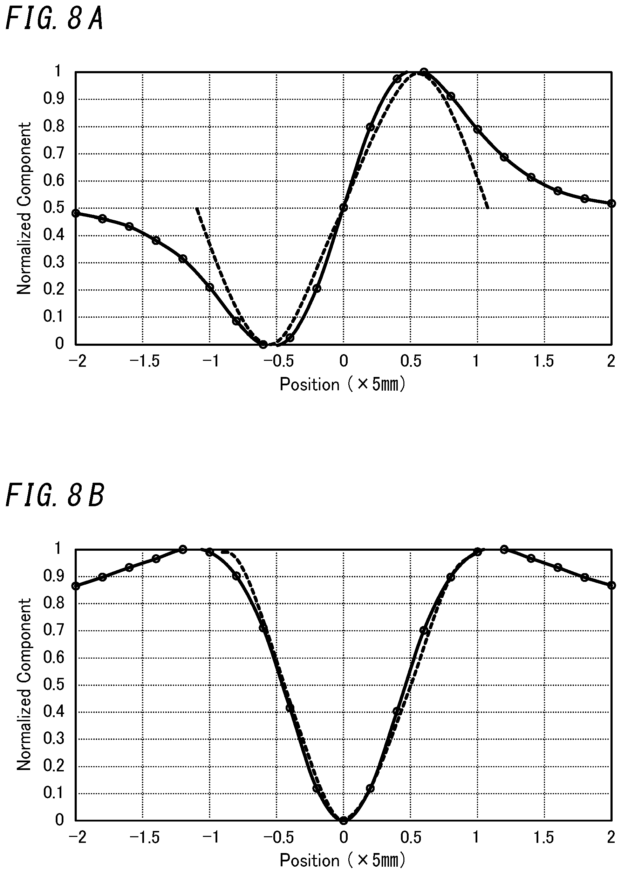

The magnetic sensor 100 is arranged such that the base member surface 73a is parallel to the magnetization direction (driving direction) and perpendicular to the magnetized surface 302a as described above. Thus, the first output signal and the second output signal (refer to FIGS. 8A and 8B) delivered from the first output terminal 1T and the second output terminal 2T, respectively, as the drive magnet 302 is displaced (moves linearly in the driving direction) come closer to a sinusoidal waveform and a cosine waveform, respectively (refer to FIGS. 8A and 8B), as the bias magnetic field (refer to FIG. 3) generated by the bias magnet 5 is superposed on the drive magnetic field (refer to FIG. 7) generated by the drive magnet 302.

Specifically, FIG. 7 indicates, by open arrows, the respective orientations of a drive magnetic field at a plurality of positions, which are located at the same distance (e.g., 1 mm from the magnetized surface 302a) in the direction (x-axis direction) perpendicular to the magnetization direction from the drive magnet 302 having a length L of 5 mm in the magnetization direction (Z-axis direction) and which are arranged at regular intervals of 0.2 mm in the direction parallel to the magnetization direction (z-axis direction).

Note that in FIG. 7, the respective cross "×" signs in the circles indicate the plurality of positions.

In addition, a (right-handed) coordinate system is also defined by the z-axis, the x-axis, and a y-axis perpendicular to the z- and x-axes with respect to the motor 300.

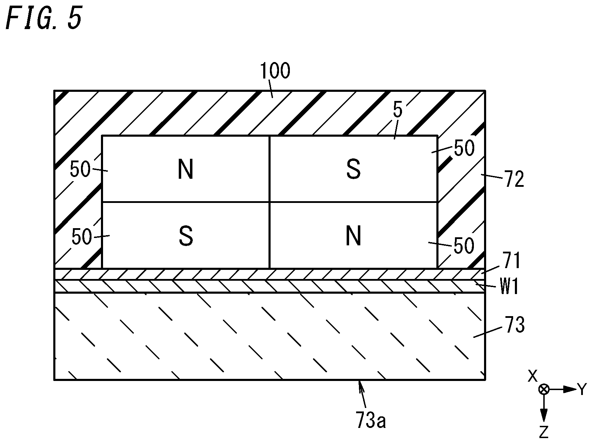

Furthermore, the z-, x-, and y-axes defined with respect to the motor 300 respectively correspond to the X-, Y-, and Z-axes (refer to FIGS. 3 and 5) defined with respect to the magnetic sensor 100.

In other words, in this position detection system 200 for use in motors, the magnetic sensor 100 is arranged, with respect to the drive magnet 302, to have such an orientation that makes the X-, Y- and Z-axes defined along the base member surface 73a as shown in FIG. 5 respectively correspond to the z-, x-, and y-axes defined along the magnetized surface 302a as shown in FIG. 7.

Arranging the magnetic sensor 100 to have such an orientation with respect to the drive magnet 302 allows the magnetic sensor 100 to detect a magnetic field in which the drive magnetic field indicated by the open arrows in FIG. 7 and the bias magnetic field indicated by the dotted lines in FIG. 3 are superposed one on top of the other.

As shown in FIG. 7, the orientation of the drive magnetic field generated by the drive magnet 302 changes, from a position located beyond the N-pole-side end portion thereof (as indicated by the top sign) through a position located before the S-pole-side end portion thereof (as indicated by the bottom sign), between various directions including a direction substantially aligned with the z-axis, a direction intermediate between the z- and x-axes, a direction substantially aligned with the x-axis, a direction intermediate between the x- and z-axes, a direction substantially aligned with the opposite direction of the z-axis, a direction intermediate between the opposite direction of the z-axis and the opposite direction of the x-axis, a direction substantially aligned with the opposite direction of the x-axis, a direction intermediate between the z-axis and the opposite direction of the x-axis, and a direction substantially aligned with the z-axis.

Thus, the first output signal and the second output signal delivered from the first output terminal 1T and the second output terminal 2T, respectively, as the drive magnet 302 is displaced come to have the signal waveforms indicated by the solid curves in FIGS. 8A and 8B, respectively.

In FIGS. 8A and 8B, the abscissa indicates a normalized position (i.e., a position in a situation where the length L of the drive magnet 302 is supposed to be 1 mm) as measured from a reference point in the magnetization direction (i.e., the center of the drive magnet 302) and the ordinate indicates a normalized component of the first output signal (i.e., a value in a situation where the length L is supposed to be 1 mm).

In FIG. 8A, the waveform of the first output signal as indicated by the solid curve substantially agrees with a sinusoidal waveform indicated by the dotted curve in the range from a position "-0.5" to a position "+0.5." Also, in FIG. 8B, the waveform of the second output signal as indicated by the solid curve substantially agrees with a cosine waveform indicated by the dotted curve in the range from a position "-0.5" to a position "+0.5."

Thus, if L = 5 mm, in the range from "-2.5 mm" to "+2.5 mm" with respect to the reference point (with a total length of 5 mm), the respective waveforms of the first output signal and the second output signal substantially agree with the sinusoidal waveform and the cosine waveform, respectively.

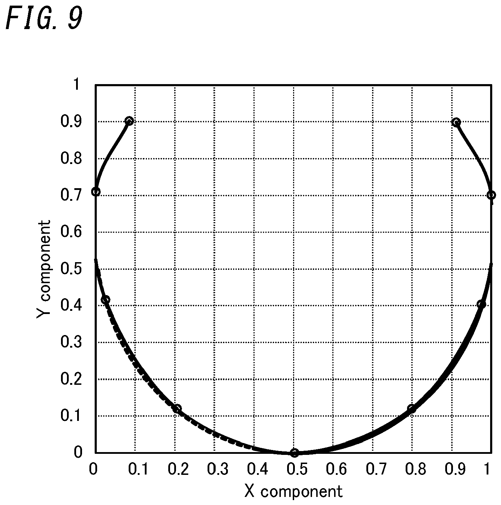

The waveform indicated by the solid curve in FIG. 9 is a Lissajous waveform corresponding to the first output signal and second output signal having such waveforms. This Lissajous waveform substantially agrees with an ideal Lissajous waveform (part of a circle) as indicated by the dotted curve in FIG. 9 in the range where the X component falls within the range from "0" to "1" and the Y component falls within the range from "0" to "0.5."

Consequently, the position detection system 200 according to this embodiment may detect the position highly accurately within the range from "-2.5 mm" to "+2.5 mm" (with a total length of 5 mm), when used in a motor 300 (a VCM for A/F in a camera module) having a drive magnet 302 where L = 5 mm, for example.

### (2-2) Signal processing

The processing circuit 201 determines, based on at least one of the first output signal or the second output signal, the orientation of a magnetic field in which a drive magnetic field applied to the magnetic sensor 100 and a bias magnetic field applied to the wiring layer W1 that forms part of the magnetic sensor 100 are superposed one on top of the other.

In this embodiment, the processing circuit 201 determines the orientation of such a magnetic field using both the first output signal and the second output signal. Specifically, the processing circuit 201 performs an arctangent operation on the first output signal and the second output signal and determines the orientation of the magnetic field based on a result of the arctangent operation. This enables ensuring a broader detection area (which is substantially as broad as the drive area) than in a situation where only the first output signal or only the second output signal is used.

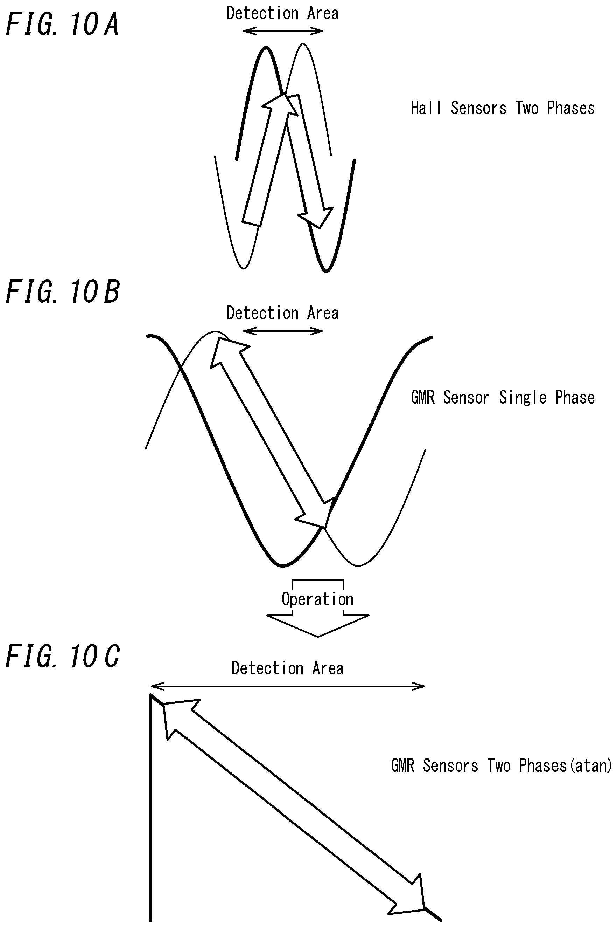

FIG. 10B shows a detection area in a situation where only one of the first output signal or the second output signal (e.g., only the first output signal) is used (labeled as "GMR Sensor Single Phase"). FIG. 10C shows a detection area in a situation where both the first output signal and the second output signal are used (labeled as "GMR Sensors Two Phases"). FIG. 10A shows, for the purpose of comparison, the detection area in a situation where two Hall elements are used (labeled as "Hall Sensors Two Phases" corresponding to the background art).

In the case of "Hall sensor two phases," the detection area is a range where respective substantially linear parts of the two phases are coupled to each other as shown in FIG. 10A, and is specifically a range from "-2 mm" to "+2 mm" (i.e., with a total length of 4 mm) with respect to the drive area from "-3 mm" to "+3 mm."

On the other hand, the detection area in the case of the "GMR sensor single phase" is a part of a range from a local maximum value of a sinusoidal waveform through a local minimum value thereof which is located over the cosine waveform as shown in FIG. 10B, and is specifically a range from "-2.5 mm" to "+0.5 mm" (i.e., with a total length of 3 mm) with respect to the drive area from "-2.5 mm" to "+2.5 mm."

Meanwhile, the detection area in the case of the "GMR sensor two phases" is substantially all of the arctangent waveform (atan) as shown in FIG. 10C and is specifically a range from "-2.5 mm" to "+2.5 mm" (i.e., with a total length of 5 mm) with respect to the drive area from "-2.5 mm" to "+2.5 mm."

The processing circuit 201 detects, based on the orientation of the magnetic field thus determined, the position of the other member selected from the coil 301 and the drive magnet 302 with respect to the position of the one member (e.g., the position of the drive magnet 302 with respect to the position of the coil 301 in this embodiment).

Consequently, this embodiment may provide a position detection system 200 for use in motors which may contribute to expanding the detection area.

According to this embodiment, the waveforms of the first output signal and the second output signal to be provided as the drive magnetic field applied to the magnetic sensor 100 moves become a waveform close to an ideal sinusoidal waveform and a waveform close to an ideal cosine waveform due to the application of the bias magnetic field. This allows the orientation of the magnetic field applied to the magnetic sensor 100 to be accurately determined based on the first output signal and the second output signal.

Optionally, the processing circuit 201 according to this embodiment may also detect the position using not only the first output signal and the second output signal but also a third output signal and a fourth output signal as well (see the "Details of processing circuit" section to be described later).

In the following description, the position detection system 200 will be described with reference to not only the X-axis and the Y-axis but also a Z-axis (of a right-handed system) which is perpendicular to both the X-axis and the Y-axis. Note that the X-, Y-, and Z-axes are virtual axes which are set on the magnetic sensor 100 (e.g., on the base member surface 73a as a surface of the base member 73) and are insubstantial ones.

### (3) Details of magnetic sensor

### (3-1) Overall configuration

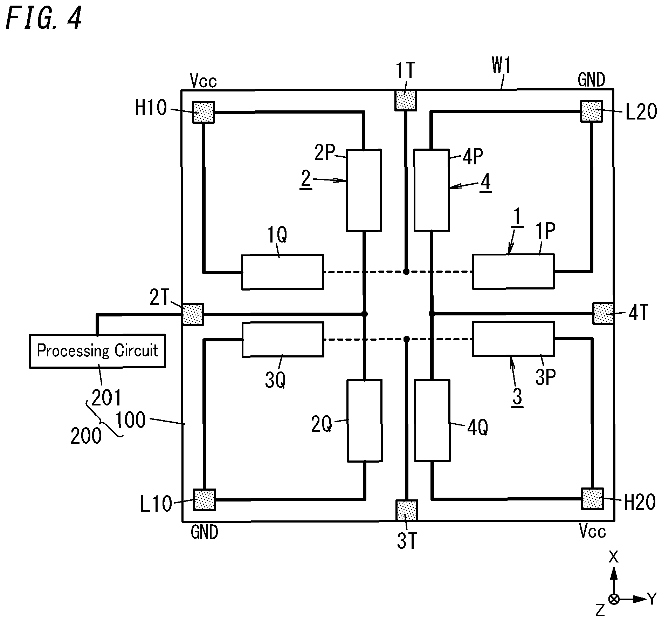

As shown in FIGS. 3-5, the magnetic sensor 100 includes a second protective film 72, the bias magnet 5, a first protective film 71, the wiring layer W1, and the base member 73. The wiring layer W1 includes the first half-bridge circuit 1, the second half-bridge circuit 2, the third half-bridge circuit 3, and the fourth half bridge circuit 4. Note that only the wiring layer W1 and the bias magnet 5 are shown in FIG. 3 and only the wiring layer W1 is shown in FIG. 4.

The position detection system 200 for use in motors includes the magnetic sensor 100 and the processing circuit 201. The processing circuit 201 determines, based on at least the first output signal and the second output signal, the orientation of the magnetic field applied to the magnetic sensor 100.

### (3-2) Bias magnet

As shown in FIGS. 3 and 5, the bias magnet 5 has a rectangular parallelepiped shape. The bias magnet 5 is a single member. As the bias magnet 5, a permanent magnet or an electromagnet may be adopted, for example. The bias magnet 5 according to this embodiment is a permanent magnet. The bias magnet 5 may be, for example, a ferrite magnet or a neodymium magnet.

The bias magnet 5 has a plurality of (e.g., eight in this embodiment) magnetic poles 50. Four magnetic poles 50 out of the eight magnetic poles 50 are arranged on a first plane which is parallel to both the X-axis and the Y-axis. The other four magnetic poles 50 out of the eight magnetic poles 50 are arranged on a second plane which is parallel to the first plane.

That is to say, two sets, each consisting of four magnetic poles 50, are provided. In each set, the four magnetic poles 50 are provided on the same plane. The magnetic poles 50 belonging to two different sets are provided at mutually different positions in the Z-axis direction. The four magnetic poles 50 shown in FIG. 3 have larger Z coordinate than the other four magnetic poles 50.

The eight magnetic poles 50 are arranged such that the magnetic poles 50 adjacent to each other in the X-axis direction have different polarities and that the magnetic poles 50 adjacent to each other in the Y-axis direction have different polarities. The eight magnetic poles 50 are also arranged such that the magnetic poles 50 adjacent to each other in the Z-axis direction have different polarities.

### (3-3) Base member

As shown in FIG. 5, the base member 73 has a plate shape. The base member 73 may be an alumina substrate, for example. In this embodiment, one of the two principal surfaces of the base member 73 (e.g., a surface opposite from the surface with the wiring layer W1) will be hereinafter referred to as a "base member surface 73a." The X-axis and the Y-axis are defined along the base member surface 73a. Alternatively, the X-axis and the Y-axis may also be defined on the other surface (i.e., the surface with the wiring layer W1) out of the two principal surfaces of the base member 73. In that case, the other principal surface will be hereinafter referred to as the "base member surface 73a."

### (3-4) Wiring layer

As shown in FIG. 5, the wiring layer W1 is provided on the surface of the base member 73 (i.e., one of the two principal surfaces which is not the base member surface 73a). Thus, the base member 73 supports the wiring layer W1 thereon. The wiring layer W1 according to this embodiment includes a plurality of layers. The plurality of layers are electrically connected to each other via a through hole.

As shown in FIG. 4, the wiring layer W1 includes the first half-bridge circuit 1, the second half-bridge circuit 2, the third half-bridge circuit 3, and the fourth half bridge circuit 4. The first half-bridge circuit 1 includes the pair of first magnetoresistance effect elements 1P, 1Q and the first output terminal 1T. The second half-bridge circuit 2 includes the pair of second magnetoresistance effect elements 2P, 2Q and the second output terminal 2T.

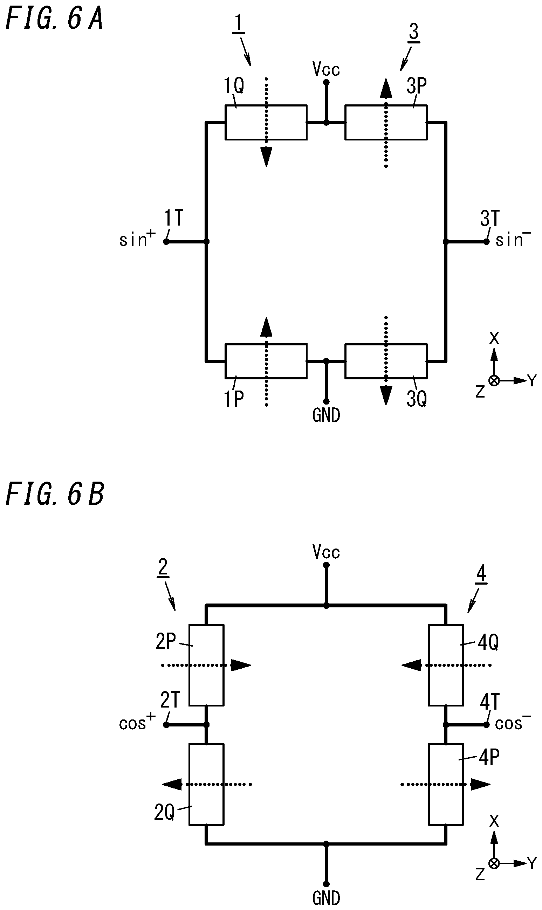

As shown in FIG. 6A, the third half-bridge circuit 3 includes a pair of third magnetoresistance effect elements 3P, 3Q and a third output terminal 3T. The pair of third magnetoresistance effect elements 3P, 3Q are half-bridge connected to each other. The pair of third magnetoresistance effect elements 3P, 3Q detects a magnetic field aligned with the X-axis. The third output terminal 3T is a terminal through which a third output signal is delivered from the connection node between the pair of third magnetoresistance effect elements 3P, 3Q.

As shown in FIG. 6B, the fourth half bridge circuit 4 includes a pair of fourth magnetoresistance effect elements 4P, 4Q and a fourth output terminal 4T. The pair of fourth magnetoresistance effect elements 4P, 4Q are half-bridge connected to each other. The pair of fourth magnetoresistance effect elements 4P, 4Q detects a magnetic field aligned with the Y-axis. The fourth output terminal 4T is a terminal through which a fourth output signal is delivered from the connection node between the pair of fourth magnetoresistance effect elements 4P, 4Q.

In the following description, the first magnetoresistance effect elements 1P, 1Q, the second magnetoresistance effect elements 2P, 2Q, the third magnetoresistance effect elements 3P, 3Q, and the fourth magnetoresistance effect elements 4P, 4Q will be hereinafter collectively referred to as "magnetoresistance effect elements Mr0." That is to say, the magnetic sensor 100 includes a plurality of (eight) magnetoresistance effect elements Mr0.

As shown in FIG. 4, the wiring layer W1 further includes power supply terminals H10, H20 and reference terminals L10, L20. The power supply terminals H10, H20 are higher-potential terminals which are electrically connected to the higher-potential electrical path of the power supply. The reference terminals L10, L20 are lower-potential terminals which are electrically connected to the lower-potential electrical path (i.e., electrical path with the reference potential) of the power supply. In this embodiment, the reference terminals L10, L20 are ground terminals electrically connected to the electrical path with the ground potential.

A first terminal of the first magnetoresistance effect element 1P is electrically connected to the reference terminal L20. A second terminal of the first magnetoresistance effect element 1P is electrically connected to a first terminal of the first magnetoresistance effect element 1Q. A second terminal of the first magnetoresistance effect element 1Q is electrically connected to the power supply terminal H10. The first output terminal 1T is electrically connected to the connection node between the pair of first magnetoresistance effect elements 1P, 1Q.

A first terminal of the second magnetoresistance effect element 2P is electrically connected to the power supply terminal H10. A second terminal of the second magnetoresistance effect element 2P is electrically connected to a first terminal of the second magnetoresistance effect element 2Q. A second terminal of the second magnetoresistance effect element 2Q is electrically connected to the reference terminal L10. The second output terminal 2T is electrically connected to the connection node between the pair of second magnetoresistance effect elements 2P, 2Q.

A first terminal of the third magnetoresistance effect element 3P is electrically connected to the power supply terminal H20. A second terminal of the third magnetoresistance effect element 3P is electrically connected to a first terminal of the third magnetoresistance effect element 3Q. A second terminal of the third magnetoresistance effect element 3Q is electrically connected to the reference terminal L10. The third output terminal 3T is electrically connected to the connection node between the pair of third magnetoresistance effect elements 3P, 3Q.

A first terminal of the fourth magnetoresistance effect element 4P is electrically connected to the reference terminal L20. A second terminal of the fourth magnetoresistance effect element 4P is electrically connected to a first terminal of the fourth magnetoresistance effect element 4Q. A second terminal of the fourth magnetoresistance effect element 4Q is electrically connected to the power supply terminal H20. The fourth output terminal 4T is electrically connected to the connection node between the pair of fourth magnetoresistance effect elements 4P, 4Q.

The first output terminal 1T, the second output terminal 2T, the third output terminal 3T, and the fourth output terminal 4T are all electrically connected to the processing circuit 201. Note that FIGS. 3 and 4 illustrate a configuration for the wiring layer W1 as if only the first output terminal 1T were connected to the processing circuit 201 for the sake of simplicity.

In FIGS. 3, 4, 6A, and 6B, the magnetoresistance effect elements Mr0 are illustrated as having a rectangular shape when viewed in the Z-axis direction. Note that this is a shape schematically illustrated to indicate the orientations of the magnetoresistance effect elements Mr0 and does not necessarily agree with the real shape of the magnetoresistance effect elements Mr0.

The electrical resistance value of each magnetoresistance effect element Mr0 varies according to the magnitude of the magnetic field applied. The magnetic sensor 100 outputs, as a voltage signal, the variation in the electrical resistance value of the magnetoresistance effect element Mr0. The magnetoresistance effect element Mr0 has no sensitivity to a magnetic field in a first direction (i.e., a direction aligned with the longer sides of the rectangle shown in FIG. 3) and has sensitivity to a magnetic field in a second direction (i.e., a direction aligned with the shorter sides of the rectangle shown in FIG. 3). The sensitivity of the magnetoresistance effect element Mr0 becomes maximum with respect to the magnetic field in the second direction.

The pair of first magnetoresistance effect elements 1P, 1Q and the pair of third magnetoresistance effect elements 3P, 3Q are arranged to exhibit sensitivity to a magnetic field having a direction aligned with the X-axis. The resistance value of the pair of first magnetoresistance effect elements 1P, 1Q and the resistance value of the pair of third magnetoresistance effect elements 3P, 3Q change in the same pattern responsive to a magnetic field aligned with the positive direction of the X-axis and a magnetic field aligned with the negative direction of the X-axis if these magnetic fields have the same magnitude.

The pair of second magnetoresistance effect elements 2P, 2Q and the pair of fourth magnetoresistance effect elements 4P, 4Q are arranged to exhibit sensitivity to a magnetic field having a direction aligned with the Y-axis. The resistance value of the pair of second magnetoresistance effect elements 2P, 2Q and the resistance value of the pair of fourth magnetoresistance effect elements 4P, 4Q change in the same pattern responsive to a magnetic field aligned with the positive direction of the Y-axis and a magnetic field aligned with the negative direction of the Y-axis if these magnetic fields have the same magnitude.

When viewed in the Z-axis direction, the respective magnetoresistance effect elements Mr0 are arranged as follows with respect to the center of the magnetic sensor 100. Specifically, the first magnetoresistance effect element 1P and the third magnetoresistance effect element 3P are arranged on the positive side of the Y-axis with respect to the center. The first magnetoresistance effect element 1Q and the third magnetoresistance effect element 3Q are arranged on the negative side of the Y-axis with respect to the center. The second magnetoresistance effect element 2P and the fourth magnetoresistance effect element 4P are arranged on the positive side of the X-axis with respect to the center. The second magnetoresistance effect element 2Q and the fourth magnetoresistance effect element 4Q are arranged on the negative side of the X-axis with respect to the center.

As described above, the Z coordinate of the four magnetic poles 50 shown in FIG. 3 is larger than the Z coordinate of the other four magnetic poles 50. That is to say, out of the plurality of magnetic poles 50 of the bias magnet 5, the four magnetic poles 50 shown in FIG. 3 face the plurality of magnetoresistance effect elements Mr0 and apply bias magnetic fields to the plurality of magnetoresistance effect elements Mr0. In FIG. 3, the orientations of the bias magnetic fields are indicated by the arrows.

A bias magnetic field aligned with the positive direction of the X-axis is applied to the first magnetoresistance effect element 1P and the third magnetoresistance effect element 3P. A bias magnetic field aligned with the negative direction of the X-axis is applied to the first magnetoresistance effect element 1Q and the third magnetoresistance effect element 3Q.

A bias magnetic field aligned with the positive direction of the Y-axis is applied to the second magnetoresistance effect element 2P and the fourth magnetoresistance effect element 4P. A bias magnetic field aligned with the negative direction of the Y-axis is applied to the second magnetoresistance effect element 2Q and the fourth magnetoresistance effect element 4Q.

As can be seen, the single bias magnet 5 generates a bias magnetic field aligned with the positive direction of the X-axis and a bias magnetic field aligned with the negative direction of the X-axis. In addition, the single bias magnet 5 also generates a bias magnetic field aligned with the positive direction of the Y-axis and a bias magnetic field aligned with the negative direction of the Y-axis.

The magnetoresistance effect elements Mr0 according to this embodiment are GMR elements. More specifically, the magnetoresistance effect elements Mr0 are current in plane (CIP) GMR elements. Alternatively, the magnetoresistance effect elements Mr0 may also be TMR elements.

Still alternatively, the magnetoresistance effect elements Mr0 may also be AMR elements. Nevertheless, GMR and TMR elements have higher sensitivity than AMR elements. Thus, using either GMR elements or TMR elements as the magnetoresistance effect elements Mr0 contributes to improving the detection accuracy of the position detection system 200 for use in motors.

Each magnetoresistance effect element Mr0 does not have sensitivity to a predetermined direction but has isotropic sensitivity to a direction intersecting with the predetermined direction.

The bias magnet 5 applies a magnetic field (bias magnetic field), of which the strength is at most one half as high as that of the anisotropic magnetic field of each of the plurality of magnetoresistance effect elements Mr0, to each of a plurality of (eight) magnetoresistance effect elements Mr0 including the pair of first magnetoresistance effect elements 1P, 1Q and the pair of second magnetoresistance effect elements 2P, 2Q. This may reduce the distortion of the output waveform of each of the plurality of magnetoresistance effect elements Mr0.

### (3-5) Protective film

As shown in FIG. 5, the first protective film 71 covers the wiring layer W1. The bias magnet 5 is mounted on the surface of the first protective film 71. The second protective film 72 covers the bias magnet 5.

### (4) Details of processing circuit

The processing circuit 201 (refer to FIG. 3) includes a computer system including one or more processors and a memory. The functions of the processing circuit 201 are performed by making the processor of the computer system execute a program stored in the memory of the computer system. The program may be stored in the memory. Alternatively, the program may also be downloaded via a telecommunications line such as the Internet or distributed after having been stored in a non-transitory storage medium such as a memory card.

The processing circuit 201 determines, based on the first output signal, the second output signal, the third output signal, and the fourth output signal, the orientation of the magnetic field (i.e., a magnetic field in which the drive magnetic field and the bias magnetic field are superposed one on top of the other) applied to the magnetic sensor 100. The first output signal, the second output signal, the third output signal, and the fourth output signal are signals delivered through the first output terminal 1T, the second output terminal 2T, the third output terminal 3T, and the fourth output terminal 4T, respectively. In other words, the first output signal, the second output signal, the third output signal, and the fourth output signal are signals output from the first half-bridge circuit 1, the second half-bridge circuit 2, the third half-bridge circuit 3, and the fourth half-bridge circuit 4, respectively.

Compare the first half-bridge circuit 1 and the third half-bridge circuit 3 with each other, and it can be seen that their magnetoresistance effect elements Mr0 have the same sensitivity direction and have a bias magnetic field with the same orientation applied thereto but the relation between the higher- and lower-potential sides in the first half-bridge circuit 1 is opposite from the relation between the higher- and lower-potential sides in the third half-bridge circuit 3 as shown in FIGS. 3 and 6A. Thus, the third output signal is a signal having an opposite phase from the first output signal.

Compare the second half-bridge circuit 2 and the fourth half-bridge circuit 4 with each other, and it can be seen that their magnetoresistance effect elements Mr0 have the same sensitivity direction and have a bias magnetic field with the same orientation applied thereto but the relation between the higher- and lower-potential sides in the second half-bridge circuit 2 is opposite from the relation between the higher- and lower-potential sides in the fourth half-bridge circuit 4 as shown in FIGS. 3 and 6B. Thus, the fourth output signal is a signal having an opposite phase from the second output signal.

### (5) Detection of magnetic field orientation

The magnetic sensor 100 is disposed in the vicinity of the drive magnet 302. The N-and S-poles of the drive magnet 302 form a magnetic field. As the drive magnet 302 moves linearly in the magnetization direction thereof, the orientation of the magnetic field applied to the magnetic sensor 100 changes. The processing circuit 201 determines, based on the output of the magnetic sensor 100, the orientation of the magnetic field applied to the magnetic sensor 100.

As the position of the drive magnet 302 with respect to the coil 301 changes parallel to the magnetization direction, the first output signal, the second output signal, the third output signal, and the fourth output signal each change in either a sinusoidal waveform or a cosine waveform.

The phase of the first output signal and the second output signal corresponds to the orientation of the magnetic field applied to the magnetic sensor 100. That is to say, the processing circuit 201 may determine, based on the first output signal and the second output signal, the orientation of the magnetic field applied to the magnetic sensor 100. More specifically, the processing circuit 201 may determine the orientation of the magnetic field applied to the magnetic sensor 100 within a range from "-L/2" to "+L/2" where L (which may be 5 mm, for example) is the length of the drive magnet 302.

In another example, the processing circuit 201 may detect the position based on not only the first output signal and the second output signal but also the third output signal and the fourth output signal as well.

Specifically, the processing circuit 201 generates a first differential signal as a differential signal between the first output signal and the third output signal. The waveform of the first differential signal is obtained by doubling the amplitude of the first output signal. In addition, the processing circuit 201 also generates a second differential signal as a differential signal between the second output signal and the fourth output signal. The waveform of the second differential signal is obtained by doubling the amplitude of the second output signal.

The processing circuit 201 may determine, based on the first differential signal and the second differential signal, a common phase for the first differential signal as a sinusoidal wave and the second differential signal as a cosine wave and may detect, based on the phase thus determined, the position of the drive magnet 302 with respect to the coil 301 (i.e., the position of the lens with respect to the camera body). The first differential signal and the second differential signal have double the amplitude of the first output signal and the second output signal, thus allowing the position to be detected more accurately.

### (6) First variation

As described above, even if the position of the magnetic sensor 100 shifts from the center of the coil surface 301a in the direction perpendicular to the magnetization direction in the position detection system 200 according to this embodiment, its detection accuracy (i.e., the broadness of the detection area) is hardly affected.

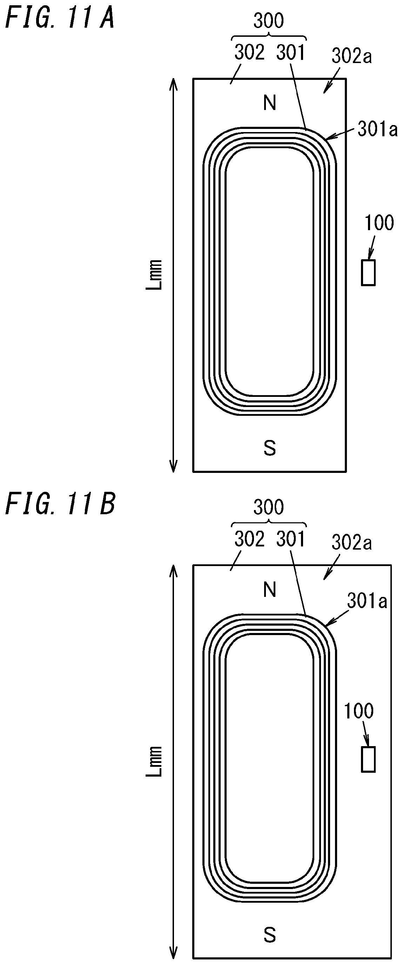

Thus, in the position detection system 200 according to the first variation, the magnetic sensor 100 is disposed outside of the coil surface 301a in the direction perpendicular to the magnetization direction when viewed from in front of the magnetized surface 302a as shown in FIG. 11A.

The magnetic sensor 100 may be located at a distance, which may be, for example, at most approximately as long as the length L (of 5 mm, for example) of the drive magnet 302 as measured in the magnetization direction, in the direction perpendicular to the magnetization direction.

Note that in the direction perpendicular to the magnetization direction, the magnetic sensor 100 may be positioned at the center of the coil surface 301a as in the exemplary embodiment described above. In the other respects, the position detection system 200 according to the first variation may also be the same as the position detection system 200 according to the exemplary embodiment described above.

This first variation contributes to allowing the magnetic sensor 100 to be placed with an increased degree of freedom while maintaining sufficient detection accuracy.

### (7) Second variation

In a position detection system 200 according to a second variation, the magnetic sensor 100 is disposed outside of the coil surface 301a but inside of the magnetized surface 302a in a direction perpendicular to the magnetization direction when viewed from in front of the magnetized surface 302a as shown in FIG. 11B.

Thus, the drive magnet 302 according to this second variation has a larger dimension (width) as measured in the direction perpendicular to the magnetization direction than the drive magnet 302 according to the exemplary embodiment (refer to FIG. 1A) or the drive magnet 302 according to the first variation (refer to FIG. 11A).

That is to say, according to the second variation, the dimension (width) of the magnetized surface 302a is larger than the (minor axis) dimension of the coil surface 301a in the direction perpendicular to the magnetization direction to such a degree that allows the magnetic sensor 100 to be located inside of the magnetized surface 302a.

Note that in the second variation, in the direction parallel to the magnetization direction, the centerline of the magnetized surface 302a is shifted toward the magnetic sensor 100 with respect to the centerline of the coil surface 301a. This reduces the dimension (width) of the magnetized surface 302a compared to a situation where these two centerlines are aligned with each other. Alternatively, the centerline of the magnetized surface 302a may be aligned with the centerline of the coil surface 301a.

This second variation contributes to further improving the detection accuracy.

### (Other variations)

Note that the drive magnet 302 does not have to be a unipolar magnetized magnet such as the one shown in FIG. 1A, for example, but may also be a multipolar magnetized magnet in which N- and S-poles are alternately arranged.

Also, the position detection system for use in motors does not have to be used to detect the position of the target of detection (e.g., the position of the drive magnet 302 with respect to the coil 301 in the exemplary embodiment and the first and second variations described above). Alternatively, the magnetic sensor 100 may also be used, for example, to detect the distance traveled by the target of detection.

Optionally, the magnetic sensor 100 may also be used in, for example, a rotary motor (not shown) including a coil and a rotor to detect the rotational angle or the number of revolutions of one member selected from the coil and the rotor with respect to the other member. Note that the rotor is a multipolar magnetized magnet which has a ringlike shape and in which N- and S-poles are arranged alternately along the circumference thereof. In the case of the rotor, the direction in which the magnetic poles are arranged (i.e., the circumferential direction) is the magnetization direction (driving direction).

### (9) Recapitulation

A position detection system (200) according to a first aspect is designed for use in a motor (300). The motor (300) includes a coil (301) to be supplied with electric power and a drive magnet (302) that applies a drive magnetic field to the coil (301). In the motor (300), the drive magnet (302) has a magnetized surface (302a) aligned with a magnetization direction and facing a coil surface (301a) of the coil (301). In the motor (300), a driving direction thereof is aligned with the magnetization direction. The driving direction is a direction in which one member selected from the group consisting of the coil (301) and the drive magnet (302) is displaced with respect to the other member. The position detection system (200) detects a position of the one member selected from the group consisting of the coil (301) and the drive magnet (302) with respect to the other member.

The position detection system (200) includes a magnetic sensor (100) and a processing circuit (201) that processes an output signal of the magnetic sensor (100). The magnetic sensor (100) is disposed at a fixed position with respect to the coil (301) and in the vicinity of the coil surface (301a) and the magnetized surface (302a). The magnetic sensor (100) delivers at least an output signal representing a magnetoresistance effect produced by the drive magnetic field generated from the drive magnet (302).

The magnetic sensor (100) includes a base member (73), a wiring layer (W1), and a bias magnet (5). The base member (73) has a base member surface (73a). The base member surface (73a) is a surface on which an X-axis and a Y-axis perpendicular to the X-axis are defined. The wiring layer (W1) is disposed along the base member surface (73a) and includes a first half bridge circuit (1) and a second half bridge circuit (2). The bias magnet (5) applies a bias magnetic field to the wiring layer (W1).

The first half-bridge circuit (1) includes a pair of first magnetoresistance effect elements (1P, 1Q) and a first output terminal (1T). The pair of first magnetoresistance effect elements (1P, 1Q) are half-bridge connected to detect a magnetic field aligned with the X-axis. The first output terminal (1T) is a terminal, through which a first output signal is delivered from a connection node between the pair of first magnetoresistance effect elements (1P, 1Q). The second half-bridge circuit (2) includes a pair of second magnetoresistance effect elements (2P, 2Q) and a second output terminal (2T). The pair of second magnetoresistance effect elements (2P, 2Q) are half-bridge connected to detect a magnetic field aligned with the Y-axis. The second output terminal (2T) is a terminal, through which a second output signal is delivered from a connection node between the pair of second magnetoresistance effect elements (2P, 2Q).

The bias magnet (5) applies a bias magnetic field aligned with a positive direction of the X-axis to one of the pair of first magnetoresistance effect elements (1P, 1Q) and applies a bias magnetic field aligned with a negative direction of the X-axis to the other of the pair of first magnetoresistance effect elements (1P, 1Q). The bias magnet (5) applies a bias magnetic field aligned with a positive direction of the Y-axis to one of the pair of second magnetoresistance effect elements (2P, 2Q) and applies a bias magnetic field aligned with a negative direction of the Y-axis to the other of the pair of second magnetoresistance effect elements (2P, 2Q).

The magnetic sensor (100) is arranged such that the base member surface (73a) is parallel to the magnetization direction and perpendicular to the magnetized surface (302a). The processing circuit (201) determines, based on at least one of the first output signal or the second output signal, an orientation of a magnetic field in which the drive magnetic field applied to the magnetic sensor (100) and the bias magnetic field applied to the wiring layer (W1) forming part of the magnetic sensor (100) are superposed one on top of the other and thereby detects the position of the one member selected from the group consisting of the coil (301) and the drive magnet (302) with respect to the other member.

This aspect may provide a position detection system (200) for use in motors which contributes to expanding the detection area.

Note that the pointing device of Patent Literature 1 uses two Hall elements. Thus, a phase shift is likely to be caused between the output signals due to, for example, the error of mounting positions where the respective Hall elements are mounted on the printed board and an individual difference between respective Hall elements, thus possibly causing a decline in position detection accuracy.

In a position detection system (200) according to a second aspect, which may be implemented in conjunction with the first aspect, only one magnetic sensor (100) is provided as the magnetic sensor (100) for the coil (301). The only one magnetic sensor (100) is disposed at a center of the coil surface (301a) in a direction parallel to the magnetization direction in front view of the magnetized surface (302a).

This aspect may contribute to further expanding the detection area while improving the detection accuracy.

Specifically, using only one magnetic sensor (100) eliminates the chances of causing a phase shift (i.e., the phase shift of the output signal due to the error during the mounting process or the difference between individual products) that is likely to be caused when two or more Hall elements are used as in Patent Literature 1, thus contributing to improving the detection accuracy.

In addition, if the position of the magnetic sensor (100) shifts from the center of the coil surface (301a) in the direction parallel to the magnetization direction, a drift would be caused in the detection area to cause one end portion of the detection area to enter a nonlinear range of an output waveform, thus causing a decline in detection accuracy at the one end portion. In other words, the detection area would become narrower. In contrast, even if the position of the magnetic sensor (100) shifts from the center of the coil surface (301a) in the direction perpendicular to the magnetization direction, the detection accuracy (i.e., the broadness of the detection area) would be hardly affected.

That is to say, the decline in the detection accuracy (i.e., the shrinkage of the detection area) of the magnetic sensor (100) due to the positional shift from the center of the coil surface (301a) is significant in the direction parallel to the magnetization direction and insignificant in the direction perpendicular to the magnetization direction.

Thus, according to this embodiment, the magnetic sensor (100) is positioned at the center of the coil surface (301a) in the direction parallel to the magnetization direction, thus contributing to improving the detection accuracy compared to a situation where the sensor position shifts from the center of the coil surface (301a).

In a position detection system (200) according to a third aspect, which may be implemented in conjunction with the second aspect, the only one magnetic sensor (100) is disposed at the center of the coil surface (301a) in a direction perpendicular to the magnetization direction in the front view of the magnetized surface (302a).

This aspect may contribute to further improving the detection accuracy.

In a position detection system (200) according to a fourth aspect, which may be implemented in conjunction with the second aspect, the only one magnetic sensor (100) is disposed outside of the coil surface (301a) in a direction perpendicular to the magnetization direction in the front view of the magnetized surface (302a).

This aspect may contribute to increasing the degree of freedom of arrangement while maintaining the detection accuracy.

In a position detection system (200) according to a fifth aspect, which may be implemented in conjunction with the fourth aspect, the only one magnetic sensor (100) is disposed inside of the magnetized surface (302a) in the direction perpendicular to the magnetization direction in the front view of the magnetized surface (302a).

According to this aspect, the magnetic sensor (100) is positioned outside of the coil surface (301a) and inside of the magnetized surface (302a), thus contributing to further improving the detection accuracy.

In a position detection system (200) according to a sixth aspect, which may be implemented in conjunction with any one of the first to fifth aspects, the processing circuit (201) performs an arctangent operation on the first output signal and the second output signal and determines an orientation of the magnetic field based on a result of the arctangent operation.

This aspect may contribute to further expanding the detection area.

In a position detection system (200) according to a seventh aspect, which may be implemented in conjunction with any one of the first to sixth aspects, the motor (300) further includes a mount board (303). The mount board (303) is a board on which the coil (301) is mounted and has a mount surface (303a) facing the coil surface (301a) of the coil (301). The magnetic sensor (100) is provided on the mount board (303) such that the base member surface (73a) is perpendicular to the mount surface (303a).

This aspect allows the magnetic sensor (100) to be fixed at a right position to have a right orientation with respect to the coil (301).

In a position detection system (200) according to an eighth aspect, which may be implemented in conjunction with any one of the first to seventh aspects, the magnetoresistance effect is a giant magnetoresistance (GMR) effect.

This aspect may contribute to improving the detection accuracy.

In a position detection system (200) according to a ninth aspect, which may be implemented in conjunction with any one of the first to seventh aspects, the magnetoresistance effect is a tunnel magnetoresistance (TMR) effect.

This aspect may contribute to improving the detection accuracy.

### Reference Signs List

- 1: First Half-Bridge Circuit
- 1P, 1Q: First Magnetoresistance Effect Element
- 1T: First Output Terminal
- 2: Second Half-Bridge Circuit
- 2P, 2Q: Second Magnetoresistance Effect Element
- 2T: Second Output Terminal
- 5: Bias Magnet
- 73: Base Member
- 73a: Base Member Surface
- 100: Magnetic Sensor
- 200: Position Detection System for Use in Motors
- 201: Processing Circuit
- 300: Motor
- 301: Coil
- 301a: Coil Surface
- 302: Drive Magnet
- 302a: Magnetized Surface
- 303: Mount Board
- 303a: Mount Surface
- Mr0: Magnetoresistance Effect Element
- W1: Wiring Layer

## Claims

1. A position detection system for use in a motor, the motor including:
a coil to be supplied with electric power; and
a drive magnet configured to apply a drive magnetic field to the coil,
the drive magnet having a magnetized surface, the magnetized surface being aligned with a magnetization direction and facing a coil surface of the coil,
the motor having a driving direction aligned with the magnetization direction, the driving direction being a direction in which one member selected from the group consisting of the coil and the drive magnet is displaced with respect to the other member selected from the group consisting of the coil and the drive magnet,
the position detection system being designed to detect a position of the one member selected from the group consisting of the coil and the drive magnet with respect to the other member selected from the group consisting of the coil and the drive magnet,
the position detection system comprising:
a magnetic sensor disposed at a fixed position with respect to the coil and in the vicinity of the coil surface and the magnetized surface, the magnetic sensor being configured to deliver at least an output signal representing a magnetoresistance effect produced by the drive magnetic field generated from the drive magnet; and
a processing circuit configured to process the output signal of the magnetic sensor,
the magnetic sensor including:
a base member having a base member surface on which an X-axis and a Y-axis perpendicular to the X-axis are defined;
a wiring layer disposed along the base member surface and including a first half-bridge circuit and a second half-bridge circuit; and
a bias magnet configured to apply a bias magnetic field to the wiring layer,
the first half-bridge circuit including:
a pair of first magnetoresistance effect elements half-bridge connected to detect a magnetic field aligned with the X-axis; and
a first output terminal through which a first output signal is delivered from a connection node between the pair of first magnetoresistance effect elements,
the second half-bridge circuit including:
a pair of second magnetoresistance effect elements half-bridge connected to detect a magnetic field aligned with the Y-axis; and
a second output terminal through which a second output signal is delivered from a connection node between the pair of second magnetoresistance effect elements,
the bias magnet being configured to
apply a bias magnetic field aligned with a positive direction of the X-axis to one of the pair of first magnetoresistance effect elements and apply a bias magnetic field aligned with a negative direction of the X-axis to the other of the pair of first magnetoresistance effect elements; and
apply a bias magnetic field aligned with a positive direction of the Y-axis to one of the pair of second magnetoresistance effect elements and apply a bias magnetic field aligned with a negative direction of the Y-axis to the other of the pair of second magnetoresistance effect elements,
the magnetic sensor being arranged such that the base member surface is parallel to the magnetization direction and perpendicular to the magnetized surface, and
the processing circuit being configured to determine, based on at least one of the first output signal or the second output signal, an orientation of a magnetic field in which the drive magnetic field applied to the magnetic sensor and the bias magnetic field applied to the wiring layer forming part of the magnetic sensor are superposed one on top of the other and thereby detect the position of the one member selected from the group consisting of the coil and the drive magnet with respect to the other member selected from the group consisting of the coil and the drive magnet.

2. The position detection system of claim 1, wherein
only one magnetic sensor is provided as the magnetic sensor for the coil, and
the only one magnetic sensor is disposed at a center of the coil surface in a direction parallel to the magnetization direction in front view of the magnetized surface.

3. The position detection system of claim 2, wherein
the only one magnetic sensor is disposed at the center of the coil surface in a direction perpendicular to the magnetization direction in the front view of the magnetized surface.

4. The position detection system of claim 2, wherein
the only one magnetic sensor is disposed outside of the coil surface in a direction perpendicular to the magnetization direction in the front view of the magnetized surface.

5. The position detection system of claim 4, wherein
the only one magnetic sensor is disposed inside of the magnetized surface in the direction perpendicular to the magnetization direction in the front view of the magnetized surface.

6. The position detection system of any one of claims 1 to 5, wherein
the processing circuit is configured to perform an arctangent operation on the first output signal and the second output signal and determine an orientation of the magnetic field based on a result of the arctangent operation.

7. The position detection system of any one of claims 1 to 6, wherein
the motor further includes a mount board, the mount board being a board on which the coil is mounted and having a mount surface facing the coil surface of the coil, and
the magnetic sensor is provided on the mount board such that the base member surface is perpendicular to the mount surface.

8. The position detection system of any one of claims 1 to 7, wherein
the magnetoresistance effect is a giant magnetoresistance effect.

9. The position detection system of any one of claims 1 to 7, wherein
the magnetoresistance effect is a tunnel magnetoresistance effect.
